# FASCICULE DE BREVET EUROPEEN

(11) **EP 1 610 462 B1**
(45) Date de publication et mention de la délivrance du brevet: **11.07.2012**
(21) Numéro de dépôt: 05105574.7
(22) Date de dépôt: 22.06.2005
(51) Int. Cl.: H03K 3/84, G06F 7/58

(54) **Circuit et procédé de vérification de la constance de biais d'un flux de bits**
Schaltungsanordnung und Verfahren zur Überprüfung der Konstanz des Bitversatzes eines Bitstroms
Circuit and method for verifying constant skew of a bitstream

(30) Priorité: 24.06.2004 FR 0451324
(43) Date de publication de la demande: 28.12.2005
(73) Titulaire: STMICROELECTRONICS S.A., 92120 Montrouge (FR)
(72) Inventeur: Liardet, Pierre-Yvan, 13790, Peynier (FR); Teglia, Yannick, 13011, Marseille (FR)
(74) Mandataire: de Beaumont, Michel

(56) Documents cités:
- EP-A- 1 320 026
- US-A1- 2003 200 239
- US-A1- 2004 096 060
- US-B1- 6 369 727
- BUCCI M ET AL: "A High Speed Truly IC Random Number Source for Smart Card Microcontrollers" ICECS 2002, 9TH IEEE INTERNATIONAL CONFERENCE ON ELECTRONICS, CIRCUITS AND SYSTEMS, vol. 1, 15 septembre 2002 (2002-09-15), pages 239-242, XP010611765 PISCATAWAY, NJ, US
- TAKEUCHI S ET AL: "HIGH PERFORMANCE RANDOM PULSER BASED ON PHOTON COUNTING" IEEE TRANSACTIONS ON NUCLEAR SCIENCE, IEEE INC. NEW YORK, US, vol. NS-33, no. 1, 1 février 1986 (1986-02-01), pages 946-949, XP002022448 ISSN: 0018-9499

## Description

### Domaine de l'invention

La présente invention concerne le domaine des générateurs de nombres aléatoires et plus précisément les générateurs de nombres aléatoires sous la forme de flux de bits issus d'une ou plusieurs sources de bruit, numériques ou numérisées.

Le document EP-A-1 320 026 divulgue un générateur de nombres aléatoires commun dans l'état de la technique.

### Exposé de l'art antérieur

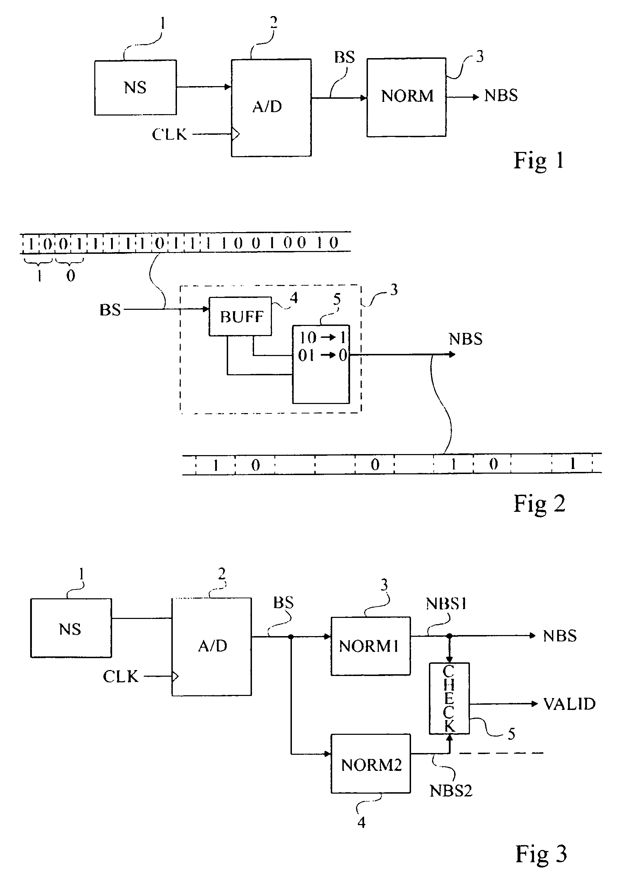

La figure 1, représente, de façon très schématique et sous forme de blocs, un exemple de générateur d'un flux de bits du type auquel s'applique la présente invention.

Un tel générateur est basé sur l'utilisation d'une source de bruit 1 (NS) fournissant un bruit analogique à un élément 2 (A/D) de conversion analogique-numérique cadencé par exemple par une horloge CLK et fournissant un flux de bits BS. La source 1 est, par exemple, constituée d'un ou plusieurs oscillateurs dont les sorties sont sommées pour fournir un bruit analogique en entrée du convertisseur 2. Le convertisseur 2 peut, de façon simplifiée, être un inverseur associé à une bascule.

La qualité d'un générateur aléatoire ou plus généralement d'une source de bruit se mesure par la qualité de son aléa, ce qui a pour conséquence l'équiprobabilité des symboles fournis, par exemple l'équiprobabilité de 0 et de 1 dans le cas où l'on considère la source bit à bit.

En pratique, le flux BS fourni par le convertisseur 2 a des risques de ne pas avoir une répartition équiprobable de ses éléments (bits ou mots de bits). En particulier, la source de bruit 1 utilise généralement des oscillateurs pour lesquels il existe un risque de synchronisation entre eux ou avec l'horloge CLK. En cas de synchronisation, l'état fourni en sortie (flux de bits) est périodique.

Pour améliorer le caractère équiprobable d'un flux de bits censé être aléatoire, le flux BS traverse un circuit 3 de normalisation (NORM) fournissant un train de bits NBS modifié et dont l'équirépartition des 0 et des 1 dans le flux est amélioré.

La figure 2 représente un exemple classique de circuit 3 de normalisation d'un flux de bits BS appliquant une méthode dite de Von Neumann. Un tel circuit 3 est basé sur une analyse du flux de bits entrant BS, par paires de bits. On utilise alors un élément de mémorisation 4 (BUFF) permettant de traiter les bits, par paires, dans un circuit 5 de détermination d'état qui fournit le flux de bits normalisé NBS. D'après la méthode de Von Neumann, si la paire de bits est 1-0, on génère un état 1. Si la paire de bits est 0-1, on génère un état 0. Si la paire de bits est 0-0 ou 1-1, on l'ignore, c'est-à-dire qu'aucun état n'est généré en sortie. D'autres méthodes de normalisation existent appliquant ou non la méthode de Von Neumann.

Un deuxième exemple de normalisation consiste à calculer un bit de parité sur une longueur prédéterminée de la source et à exploiter uniquement ce bit de parité. Cette méthode a été décrite dans le document RFC 1750 en décembre 1994.

En principe, le nombre d'apparitions de 0 et de 1 dans le flux BS est constant, ce qui signifie que le biais (skew) - ou la dérive - de la source de bruit est constante au cours du temps. En effet, si cette propriété n'est pas respectée côté source de bruit, le circuit de normalisation n'a pas l'effet escompté de supprimer cette dérive dans le flux de bits.

L'efficacité d'un circuit de normalisation d'un flux de bits censé être aléatoire est particulièrement importante dans la mesure ou les nombres aléatoires sont souvent utilisés dans des applications de chiffrement ou analogues pour lesquels la perte du caractère aléatoire du nombre constitue une faiblesse.

Un inconvénient des générateurs normalisés de nombres aléatoires actuels est qu'on ne sait pas vérifier l'élimination d'un biais éventuel par le circuit de normalisation. Cela vient notamment du fait que les méthodes de normalisation ne fonctionnent qu'en supposant, a priori, que le biais de la source de bruit est constant.

Un premier problème et que si ce biais devient non constant, le flux de bits fourni par le circuit de normalisation ne respecte plus l'équirépartition souhaitée sans que l'on s'en aperçoive.

Un deuxième problème est qu'une équirépartition sur un grand nombre de bits pourrait se vérifier a posteriori en sortie d'un circuit de normalisation, mais que l'on ne sait pas aujourd'hui vérifier dynamiquement ce caractère aléatoire pour détecter rapidement une éventuelle perte de constance du biais dans la source de bruit.

La présente invention vise à vérifier la constance du biais d'un flux de bits fourni par un circuit de normalisation et, en particulier, à détecter dynamiquement une dérive.

La présente invention vise également à proposer une solution compatible avec des méthodes de normalisation classiques et qui, notamment, ne requiert aucune modification de la génération du flux de bits aléatoire en elle-même.

L'invention vise également à proposer une solution de mise en oeuvre simple.

### Résumé de l'invention

Pour atteindre ces objets ainsi que d'autres, la présente invention prévoit un circuit de génération d'un flux de bits à partir d'une source de bruit et d'au moins un premier élément de normalisation du flux de bits initial fourni par cette source de bruit, comportant des moyens pour calculer l'écart entre les débits d'entrée et de sortie du circuit de normalisation.

L'invention prévoit également un circuit de génération d'un flux de bits à partir d'une source de bruit et d'au moins un premier élément de normalisation du flux de bits initial fourni par cette source de bruit, comportant au moins un deuxième élément de normalisation de la même source de bruit, de débit différent par rapport au premier élément ; et un élément de calcul de l'écart entre les débits respectifs des deux éléments de normalisation.

Selon un mode de réalisation de la présente invention, le circuit fournit un bit de validation du caractère équiprobable du flux de sortie si ledit écart entre les deux débits reste dans une plage de valeurs prédéterminée.

L'invention prévoit également un procédé de détection d'une éventuelle perte de caractère équiprobable d'un premier flux de bits de sortie issu d'au moins un premier élément de normalisation d'un flux de bits initial, caractérisé en ce qu'il consiste à vérifier la constance du rapport entre les débits du flux de sortie sur le flux initial.

L'invention prévoit également un procédé de détection d'une éventuelle perte de caractère équiprobable d'un premier flux de bits de sortie issu d'au moins un premier élément de normalisation d'un flux de bits initial, consistant à soumettre le flux initial à au moins un deuxième élément de normalisation de débit différent du premier ; et vérifier la constance de l'écart entre les débits respectifs des flux de sortie.

Selon un mode de réalisation de la présente invention, on considère une perte du caractère équiprobable du flux de bits de sortie en cas de débit non constant.

Selon un mode de réalisation de la présente invention, on vérifie la constance du rapport entre les débits du flux de sortie sur le flux initial.

### Brève description des dessins

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 et 2 qui ont été décrites précédemment sont destinées à exposer l'état de la technique et le problème posé ; et
la figure 3 représente, de façon très schématique et sous forme de blocs, un mode de réalisation d'un circuit de validation du caractère aléatoire d'un flux de bits selon la présente invention.

### Description détaillée

Les mêmes éléments ont été désignés par les mêmes références aux différentes figures. Pour des raisons de clarté, seuls les éléments qui sont nécessaires à la compréhension de l'invention ont été représentés aux figures et seront décrits par la suite. En particulier, les détails constitutifs des circuits de normalisation, des convertisseurs analogique-numériques et de la source de bruit n'ont pas été exposés, l'invention étant compatible avec n'importe quelle réalisation classique.

Une première solution non représentée est de vérifier la constance du débit du circuit de normalisation. En particulier, si le débit de bits d'entrée est constant, le fait d'avoir le débit de bits en sortie du normalisateur constant signifie bien, notamment pour un normalisateur de type Von Neumann, une fréquence régulière d'apparition de paires 00 et 11. Pour tenir compte d'une éventuelle variation du débit d'entrée, on peut calculer le rapport du nombre de bits de sortie (flux NBS, figure 1 ou 2) sur le nombre de bits (BS) d'entrée. Si ce rapport est constant au cours du temps, cela signifie que la dérive de la source de bruit (biais) l'est également et que, par conséquent, les résultats du circuit de normalisation sont fiables. En variante, on peut calculer le rapport inverse et plus généralement n'importe quelle fonction vérifiant l'écart de débit entre les flux BS et NBS.

Cette première solution constitue déjà une amélioration par rapport à l'absence de solution pour détecter une éventuelle dérive. Toutefois, une imperfection est que, sur une courte période, il n'est pas possible de savoir si un changement du rapport entre les nombres de bits de sortie et d'entrée provient d'un changement du biais de la source de bruit entraînant une inefficacité du circuit de normalisation, ou à une structure particulière du flux de bits d'entrée (par exemple, une suite de paires d'états 00 trop longue) qui n'est alors pas gênante (au moins pour ce qui concerne l'efficacité du normalisateur), et qui est aussi probable qu'une autre suite de bits.

Selon un mode de réalisation préféré de la présente invention, on valide le caractère équiprobable du flux de bits fourni par un circuit de normalisation, en analysant le rapport entre les débits respectifs de ce flux et d'un autre flux généré par un circuit de normalisation parallèle. En d'autres termes, on prévoit de traiter le flux de bits fourni par un convertisseur analogique-numérique par deux circuits de normalisation en parallèle afin de vérifier que le biais de la source de bruit d'entrée est bien constant.

Selon l'invention, les deux circuits de normalisation sont choisis pour être différents l'un de l'autre en terme de débit. Cela signifie que les valeurs moyennes respectives des rapports entre le nombre de bits produits et le nombre de bits en entrée sont différentes.

La figure 3 représente, de façon très schématique et sous forme de blocs, un mode de réalisation d'un circuit de génération d'un flux de bits aléatoire mettant en oeuvre la présente invention.

Comme précédemment, une source de bruit par exemple analogique 1 (NS) fournit à un convertisseur 2 (A/D) un signal analogique qui, en étant par exemple échantillonné par un signal d'horloge CLK, devient un train de bits BS.

Selon ce mode de réalisation de l'invention, le flux BS est envoyé, en parallèle, sur un premier circuit 3 (NORM1) de normalisation fournissant un premier flux de bits normalisé NBS1 et sur un deuxième circuit 4 (NORM2) de normalisation fournissant un deuxième flux de bits normalisé NBS2.

Les circuits de normalisation 3 et 4 peuvent mettre en oeuvre n'importe quel procédé de normalisation classique (Von Neumann ou autre) pourvu que, pour un même flux de bits d'entrée, le rapport entre le nombre de bits produits et le nombre de bits d'entrée soit différent d'un circuit à l'autre. Par exemple, un premier élément de normalisation traite les bits par paires et fournit un 1 pour chaque paire 1-0 et un 0 pour chaque paire 0-1 sans changer les états des autres paires. Un deuxième élément de normalisation traite les bits par triplets et fournit un 1 pour chaque triplet 1-0-1 et un 0 pour chaque triplet 0-1-1 sans changer les états des autres triplets.

Selon l'invention, on vérifie que (bloc 5, CHECK) l'écart entre les débits des flux NBS1 et NBS2 reste dans une plage prédéterminée considérée comme acceptable. Par exemple, on calcule le rapport entre les débits des flux NBS1 et NBS2 (ou le rapport inverse) et on vérifie (par des comparaisons de valeur) que ce rapport reste dans une plage de valeurs prédéterminée.

Si ce rapport reste constant (dans la plage prédéterminée), cela signifie que les deux circuits de normalisation modifient le flux d'entrée BS en maintenant le biais de la source de bruit constant et, par conséquent, que n'importe lequel des flux des bits NBS1 et NBS2 fournis en sortie a un caractère équiprobable. Dans l'exemple de la figure 3, c'est le flux du premier normalisateur NBS1 qui fournit le flux NBS du générateur aléatoire.

Par contre, si la source de bruit 1 a un biais non constant, les deux circuits de normalisation vont modifier le flux de bits mais, comme ils sont de débits différents, sans modifier le caractère non constant du flux d'entrée BS. Par conséquent, le rapport entre les débits ne reste pas constant.

Selon un exemple de réalisation, le bloc 5 fournit un bit d'état VALID indicateur de la constance du rapport entre les débits des flux NBS1 et NBS2. En pratique, on fournira une plage acceptable de variation du rapport de production des deux circuits de normalisation. En effet, la période sur laquelle est examiné le rapport entre les débits des deux circuits de normalisation doit être compatible avec la fourniture, par le circuit de normalisation, d'un flux de bits aléatoire.

Selon un exemple particulier de réalisation, on prévoit une période d'examen des rapports de normalisation de 32 bits.

L'exploitation du résultat du bloc 5 dépend de l'application. Par exemple, si le rapport varie, le flux de bits généré n'est pas utilisé car cela signifie que les bits ne sont pas équirépartis de façon satisfaisante.

Bien entendu, la présente invention est susceptible de diverses variantes et modifications qui apparaîtront à l'homme de l'art. En particulier, le choix du circuit de normalisation à utiliser dépend de l'application qui peut conditionner l'utilisation d'un type de circuit de normalisation plutôt qu'un autre.

De plus, la réalisation pratique de l'invention, que ce soit par des moyens matériels et/ou logiciels, est à la portée de l'homme du métier à partir des indications fonctionnelles données ci-dessus. Par exemple, le calcul de débit est effectué au moyen de compteurs des nombres de bits produits sur une période prédéterminée, les résultats des compteurs étant mis en rapport à l'issu de chaque période, puis réinitialisés. Le cas échéant, les rapports sont calculés avec une périodicité différente (plus grande) que la période de réinitialisation des compteurs.

En outre, bien que l'invention ait été décrite en relation avec un circuit de normalisation de type Von Neumann exploitant des paires de bits, elle s'applique plus généralement quelle que soit la longueur (paire ou impaire) des mots ou tronçons de flux entrants considérés par les circuits de normalisation. Par exemple, les bits entrants peuvent être traités quatre par quatre.

## Revendications

1. Circuit de génération d'un flux de bits (NBS) à partir d'une source de bruit (1) et d'au moins un premier élément (3) de normalisation du flux de bits initial (BS) fourni par cette source de bruit, **caractérisé en ce qu'**il comporte des moyens pour calculer l'écart entre les débits d'entrée et de sortie du circuit de normalisation.

2. Circuit de génération d'un flux de bits (NBS) à partir d'une source de bruit (1) et d'au moins un premier élément (3) de normalisation du flux de bits initial (BS) fourni par cette source de bruit, **caractérisé en ce qu'**il comporte :
au moins un deuxième élément (4) de normalisation de la même source de bruit, de débit différent par rapport au premier élément ; et
un élément (5) de calcul de l'écart entre les débits respectifs des deux éléments de normalisation.

3. Circuit selon la revendication 2, fournissant un bit (VALID) de validation du caractère équiprobable du flux de sortie (NBS) si ledit écart entre les deux débits reste dans une plage de valeurs prédéterminée.

4. Procédé de détection d'une éventuelle perte de caractère équiprobable d'un premier flux de bits de sortie issu d'au moins un premier élément de normalisation (3) d'un flux de bits initial (BS), **caractérisé en ce qu'**il consiste à vérifier la constance du rapport entre les débits du flux de sortie (NBS) sur le flux initial (BS).

5. Procédé de détection d'une éventuelle perte de caractère équiprobable d'un premier flux de bits de sortie (NBS1) issu d'au moins un premier élément de normalisation (3) d'un flux de bits initial (BS), **caractérisé en ce qu'**il consiste à :
soumettre le flux initial (BS) à au moins un deuxième élément de normalisation (4) de débit différent du premier ; et
vérifier la constance de l'écart entre les débits respectifs des flux de sortie (NBS1, NBS2).

6. Procédé selon la revendication 4, dans lequel on considère une perte du caractère équiprobable du flux de bits de sortie en cas de débit non constant.

7. Procédé selon la revendication 5, consistant à vérifier la constance du rapport entre les débits du flux de sortie (NBS) sur le flux initial (BS).

## Claims

1. A circuit for generating a bit flow (NBS) based on a noise source (1) and on at least one first element (3) for normalizing the initial bit flow (BS) provided by this noise source, **characterized in that** it comprises means for calculating the difference between the input and output flow rates of the normalization circuit.

2. A circuit for generating a bit flow (NBS) based on a noise source (1) and on at least one first element (3) for normalizing the initial bit flow (BS) provided by this noise source, **characterized in that** it comprises:
at least one second normalization element (4) of the same noise source, of a different flow rate than the first element; and
an element (5) for calculating the difference between the respective flow rates of the two normalization elements.

3. The circuit of claim 2, providing a bit (VALID) for validating the equiprobable character of the output flow (NBS) if said difference between the two flow rates remains within a predetermined range of values.

4. A method for detecting a possible loss in the equiprobable character of a first output bit flow originating from at least one first element of normalization (3) of an initial bit flow (BS), **characterized in that** it comprises checking the constancy of the ratio of the rate of the output flow (NBS) to the initial flow (BS).

5. A method for detecting a possible loss in the equiprobable character of a first output bit flow (NBS1) originating from at least one first element of normalization (3) of an initial bit flow (BS), **characterized in that** it comprises:
submitting the initial flow (BS) to at least one second flow rate normalization element (4) different from the first one; and
checking the constancy of the difference between the respective output flow rates (NBS1, NBS2).

6. The method of claim 4, wherein a loss in the equiprobable character of the output bit flow in case of a non-constant flow rate is considered.

7. The method of claim 5, comprising checking the constancy of the ratio of the rates of the output flow (NBS) to the initial flow (BS).

## Patentansprüche

1. Ein Schaltkreis zum Erzeugen eines Bitflusses (NBS) basierend auf einer Rauschquelle (1) und auf wenigstens einem ersten Element (3) zum Normalisieren des initialen Bitflusses (BS), der von der Rauschquelle bereitgestellt wird, **dadurch gekennzeichnet, dass** der Schaltkreis Mittel zum Berechnen der Differenz zwischen der Eingangs- und der Ausgangsflussrate des Normalisierungsschaltkreises aufweist.

2. Ein Schaltkreis zum Erzeugen eines Bitflusses (NBS) basierend auf einer Rauschquelle (1) und auf wenigstens einem ersten Element (3) zum Normalisieren des initialen Bitflusses (BS), der von der Rauschquelle bereitgestellt wird, **dadurch gekennzeichnet, dass** der Schaltkreis Folgendes aufweist:
wenigstens ein zweites Normalisierungselement (4) derselben Rauschquelle mit einer unterschiedlichen Flussrate als das erste Element; und
ein Element (5) zum Berechnen der Differenz zwischen den entsprechenden Flussraten der zwei Normalisierungselemente.

3. Der Schaltkreis nach Anspruch 2, wobei der Schaltkreis ein Bit (VALID) bereitstellt, zum Validieren des gleichwahrscheinlichen Charakters des Ausgabeflusses (NBS), wenn die Differenz zwischen den beiden Flussraten innerhalb eines vorbestimmten Bereiches von Werten bleibt.

4. Ein Verfahren zum Detektieren eines möglichen Verlustes in dem gleichwahrscheinlichen Charakter eines ersten Ausgabebitflusses, der von wenigstens einem ersten Element zur Normalisierung (3) eines initialen Bitflusses (BS) herrührt, **dadurch gekennzeichnet, dass** das Verfahren das Überprüfen der Konstanz des Verhältnisses der Rate des Ausgabeflusses (NBS) zu dem initialen Fluss (BS) aufweist.

5. Ein Verfahren zum Detektieren eines möglichen Verlustes in dem gleichwahrscheinlichen Charakter eines ersten Ausgabebitflusses (NBS1), der von wenigstens einem ersten Element zur Normalisierung (3) eines initialen Bitflusses (BS) herrührt, **dadurch gekennzeichnet, dass** das Verfahren Folgendes aufweist:
Bereitstellen des initialen Flusses (BS) an wenigstens ein zweites Flussratennormalisierungselement (4), das unterschiedlich zu dem ersten ist; und
Überprüfen der Konstanz des Unterschieds zwischen den entsprechenden Ausgabeflussraten (NBS1, NBS2).

6. Das Verfahren nach Anspruch 4, wobei ein Verlust in dem gleichwahrscheinlichen Charakter des Ausgabebitflusses im Fall einer nicht konstanten Flussrate betrachtet wird.

7. Das Verfahren nach Anspruch 5, wobei das Verfahren das Überprüfen der Konstanz des Verhältnisses der Rate des Ausgabeflusses (NBS) zu der Rate des initialen Fluss (BS) aufweist.
